# EUROPEAN PATENT APPLICATION

(11) **EP 4 782 568 A2**
(43) Date of publication of application: **29.07.2026**
(21) Application number: 25221898.7
(22) Date of filing: 09.12.2025
(51) Int. Cl.: C23C 16/40, C23C 16/509

(54) **SILOXANE COMPOUND FILM, MEMBER, FIXING DEVICE, IMAGE FORMING APPARATUS, AND METHOD OF MANUFACTURING SILOXANE COMPOUND FILM**

(30) Priority: 24.01.2025 JP 2025010970
(71) Applicant: FUJIFILM Business Innovation Corp., Minato-ku Tokyo (JP)
(72) Inventor: IWANAGA, Takeshi, Ebina-shi, Kanagawa (JP); ONO, Masato, Ebina-shi, Kanagawa (JP); SEKIGUCHI, Ryo, Ebina-shi, Kanagawa (JP); SEKO, Masayuki, Ebina-shi, Kanagawa (JP)
(74) Representative: Becker Kurig & Partner Patentanwälte mbB

(57) **Abstract**

A siloxane compound film contains a siloxane compound including Si, O, C, and H as constituent elements, in which the siloxane compound film has a peak in a range of 100 eV or more and 103 eV or less in a spectrum measured by X-ray photoelectron spectroscopy (XPS), and a half-value width of the peak is 1.80 eV or more and 4.00 eV or less.

## Description

### BACKGROUND OF THE INVENTION

### (i) Field of the Invention

The present invention relates to a siloxane compound film, a member, a fixing device, an image forming apparatus, and a method of manufacturing a siloxane compound film.

### (ii) Description of Related Art

For example, JP2015-227932A discloses "fixing member that is used for fixing, onto a recording medium, a recording material that has been applied onto the recording medium, the fixing member including a base material and a release layer as an outermost layer on the base material, in which the release layer consists of a silicon oxide film containing carbon atoms, an infrared absorption spectrum of the release layer has an absorption peak derived from Si-CH₃, and a carbon atom concentration in the release layer [(number of carbon atoms in the silicon oxide film) × 100/(number of carbon atoms in the silicon oxide film + number of silicon atoms in the silicon oxide film + number of oxygen atoms in the silicon oxide film)] is 40 atomic% or more and 72 atomic% or less".

### SUMMARY OF THE INVENTION

An object of the present invention is to provide a siloxane compound film that has release properties and achieves both abrasion resistance and flexibility, as compared with a case where a half-value width of a peak in a range of 100 eV or more and 103 eV or less in a spectrum measured by X-ray photoelectron spectroscopy (XPS) is less than 1.80 eV or more than 4.00 eV.

Methods for achieving the above object include the following aspects.
<1>
   According to a first aspect of the present disclosure, there is provided a siloxane compound film containing:
   a siloxane compound including Si, O, C, and H as constituent elements,
   in which the siloxane compound film has a peak in a range of 100 eV or more and 103 eV or less in a spectrum measured by X-ray photoelectron spectroscopy (XPS), and
   a half-value width of the peak is 1.80 eV or more and 4.00 eV or less.
<2> According to a second aspect of the present disclosure, there is provided the siloxane compound film according to <1>,
   in which the siloxane compound film may have an Si-O bond and an Si-R bond (R represents a group including at least one of an alkyl group or a phenyl group).
<3> According to a third aspect of the present disclosure, there is provided the siloxane compound film according to <2>,
   in which R may represent a group including an alkyl group.
<4> According to a fourth aspect of the present disclosure, there is provided the siloxane compound film according to any one of <1> to <3>,
   in which the half-value width of the peak may be 2.00 eV or more and 3.00 eV or less.
<5> According to a fifth aspect of the present disclosure, there is provided the siloxane compound film according to any one of <1> to <4>,
   in which an atomic weight ratio (C/Si) of C to Si may be 0.30 or more.
<6> According to a sixth aspect of the present disclosure, there is provided a member including:
   a base material; and
   a surface layer that is provided on the base material and is constituted of the siloxane compound film according to any one of <1> to <5>.
<7> According to a seventh aspect of the present disclosure, there is provided the member according to <6>,
   in which the base material may be a metal base material.
<8> According to an eighth aspect of the present disclosure, there is provided a fixing device including:
   a first rotating body; and
   a second rotating body disposed in contact with an outer surface of the first rotating body,
   in which at least one of the first rotating body or the second rotating body is constituted of the member according to <6> or <7>.
<9> According to a ninth aspect of the present disclosure, there is provided an image forming apparatus including:
   an image holder;
   a charging device that charges a surface of the image holder;
   an electrostatic latent image forming device that forms an electrostatic latent image on the charged surface of the image holder;
   a developing device that accommodates a developer containing a toner and develops the electrostatic latent image formed on the surface of the image holder with the developer to form a toner image;
   a transfer device that transfers the toner image onto a surface of a recording medium; and
   the fixing device according to <8>, that fixes the toner image on the surface of the recording medium.
<10> According to a tenth aspect of the present disclosure, there is provided a method of manufacturing the siloxane compound film according to any one of <1> to <5>, the method including:
   forming the siloxane compound film by plasma enhanced chemical vapor deposition (plasma CVD) using a raw material siloxane compound as a raw material.

According to <1> or <2>, there is provided a siloxane compound film that has release properties and achieves both abrasion resistance and flexibility, as compared with a case where a half-value width of a peak in a range of 100 eV or more and 103 eV or less in a spectrum measured by X-ray photoelectron spectroscopy (XPS) is less than 1.80 eV or more than 4.00 eV.

According to <3>, there is provided a siloxane compound film that has release properties and achieves both abrasion resistance and flexibility, as compared with a case where R represents a group including a phenyl group.

According to <4>, there is provided a siloxane compound film that has release properties and achieves both abrasion resistance and flexibility, as compared with a case where the half-value width of the peak is less than 2.00 eV or more than 3.00 eV.

According to <5>, there is provided a siloxane compound film that has release properties and achieves both abrasion resistance and flexibility, as compared with a case where the atomic weight ratio (C/Si) is less than 0.30.

According to <6>, <7>, <8>, or <9>, there is provided a member including a siloxane compound film that has release properties and achieves both abrasion resistance and flexibility, or a fixing device or an image forming apparatus including the member, as compared with a case where a half-value width of a peak in a range of 100 eV or more and 103 eV or less in a spectrum measured by X-ray photoelectron spectroscopy (XPS) is less than 1.80 eV or more than 4.00 eV.

According to <10>, there is provided a method of manufacturing a siloxane compound film, in which the siloxane compound film that has release properties and achieves both abrasion resistance and flexibility is obtained by plasma CVD, as compared with a case of a method of manufacturing a siloxane compound film in which a half-value width of a peak in a range of 100 eV or more and 103 eV or less in a spectrum measured by X-ray photoelectron spectroscopy (XPS) is less than 1.80 eV or more than 4.00 eV.

### BRIEF DESCRIPTION OF THE DRAWINGS

Exemplary embodiment(s) of the present invention will be described in detail based on the following figures, wherein:
FIGS. 1A and 1B are views schematically showing a configuration of an example of a film forming device used for forming a siloxane compound film according to the present exemplary embodiment;
FIG. 2 is a view schematically showing a configuration of an example of a fixing device according to the present exemplary embodiment; and
FIG. 3 is a view schematically showing a configuration of an example of an image forming apparatus according to the present exemplary embodiment.

### DETAILED DESCRIPTION OF THE INVENTION

Hereinafter, present exemplary embodiments of the present invention will be described. The following descriptions and examples merely illustrate the exemplary embodiments, and do not limit the scope of the exemplary embodiments.

Regarding the numerical ranges described in stages in the present exemplary embodiment, the upper limit value or lower limit value of a numerical range may be replaced with the upper limit value or lower limit value of another numerical range described in stages. In addition, in the present exemplary embodiment, the upper limit value or lower limit value of a numerical range may be replaced with values described in examples.

In the present exemplary embodiments, the term "step" includes not only an independent step but a step which is not clearly distinguished from other steps as long as the intended purpose of the step is achieved.

In the present exemplary embodiment, in a case where an exemplary embodiment is described with reference to drawings, the configuration of the exemplary embodiment is not limited to the configuration shown in the drawings. In addition, the sizes of members in each drawing are conceptual and do not limit the relative relationship between the sizes of the members.

In the present exemplary embodiments, each component may include a plurality of corresponding substances. In the present exemplary embodiment, in a case where the amount of each component in a composition is mentioned, and there are two or more kinds of substances corresponding to each component in the composition, unless otherwise specified, the amount of each component means the total amount of two or more kinds of the substances present in the composition.

### <Siloxane Compound Film>

The siloxane compound film according to the present exemplary embodiment contains a siloxane compound including Si, O, C, and H as constituent elements.

The siloxane compound film has a peak in a range of 100 eV or more and 103 eV or less in a spectrum measured by X-ray photoelectron spectroscopy (XPS), and a half-value width of the peak is 1.80 eV or more and 4.00 eV or less.

It is considered that, with the above-described configuration, the siloxane compound film according to the present exemplary embodiment has a D unit (oxidation valence of Si: 2) that imparts flexibility, a T unit (oxidation valence of Si: 3) that imparts release properties, and a Q unit (oxidation valence of Si: 4) that imparts abrasion resistance in a balanced manner.

Therefore, the siloxane compound film according to the present exemplary embodiment is a siloxane compound film that has release properties and achieves both abrasion resistance and flexibility.

Hereinafter, details of the siloxane compound film according to the present exemplary embodiment will be described.

### (Measurement value by X-ray photoelectron spectroscopy (XPS))

The siloxane compound film according to the present exemplary embodiment has a peak in a range of 100 eV or more and 103 eV or less in a spectrum measured by X-ray photoelectron spectroscopy (XPS), and a half-value width of the peak is 1.80 eV or more and 4.00 eV or less.

The peak in the range of 100 eV or more and 103 eV or less is a peak derived from Si.

In a case where the half-value width of the peak is less than 1.80 eV, the siloxane compound film has excessive D units, and thus has flexibility but has low abrasion resistance; or has excessive Q units, and thus has abrasion resistance but has low flexibility.

In order for the half-value width of the peak to be more than 4.00 eV, it is required to include a certain amount or more of an M unit (oxidation valence of Si: 1, a unit represented by (R₃SiO_{1/2})ₙ, where R = a substituent), and the M unit corresponding to the bonding terminal is too large to be stable as a solid or to form a mechanically brittle film. Therefore, the siloxane compound film cannot be formed.

Accordingly, the half-value width of the peak is within the above-described range.

The half-value width of the peak is, for example, preferably 2.00 eV or more and 3.00 eV or less.

Examples of a method of setting the half-value width of the peak to be within the above-described range include a method of forming a film with a siloxane compound including the D unit, the T unit, and the Q unit in appropriate ranges, which will be described later.

The half-value width of the peak is measured using an X-ray photoelectron spectrometer "JPS-9030" manufactured by JEOL Ltd. Specifically, the measurement is performed as follows.

In the X-ray photoelectron spectrometer, under conditions of an acceleration voltage of 10 [kV] and an emission current of 20 [mA], MgKα rays having a photon energy of 1253.6 [eV] are generated, and a sample of the siloxane compound film to be measured is irradiated with X-rays.

A narrow spectrum of Si having a peak in a range of 100 eV or more and 103 eV or less is acquired under conditions of a start energy of 108.243 [eV], an end energy of 95.243 [eV], and a step of 0.1 [eV].

Next, the half-value width of the narrow spectrum of Si is calculated using "XPS analysis software SpecSurf" attached to the X-ray photoelectron spectrometer "JPS-9030" manufactured by JEOL Ltd.

### (Formulation)

The siloxane compound film according to the present exemplary embodiment contains a siloxane compound including Si, O, C, and H as constituent elements.

Specifically, from the viewpoint of improving high-temperature release properties, for example, the siloxane compound film (that is, the siloxane compound) preferably has an Si-O bond and an Si-R bond.

Here, R represents a group including at least one of an alkyl group or a phenyl group. From the viewpoint of improving the release properties, for example, R preferably represents a group including an alkyl group.

In the siloxane compound film according to the present exemplary embodiment, an atomic weight ratio (C/Si) of C to Si is, for example, preferably 0.30 or more, more preferably 0.50 or more, and still more preferably 1.00 or more.

In a case where the atomic weight ratio (C/Si) is within the above-described range, the release properties, the abrasion resistance, and the flexibility are improved. In particular, the high-temperature release properties are improved.

However, from the viewpoint of mechanical strength and material stability, the atomic weight ratio (C/Si) of C to Si is, for example, preferably 20 or less.

In the siloxane compound film according to the present exemplary embodiment, an atomic weight ratio (O/Si) of O to Si is, for example, preferably 0.50 or more and 2.00 or less, more preferably 0.70 or more and 1.80 or less, and still more preferably 0.80 or more and 1.50 or less.

In a case where the atomic weight ratio (O/Si) is within the above-described range, the release properties, the abrasion resistance, and the flexibility are improved. In particular, the high-temperature release properties are improved.

Examples of a method of setting the atomic weight ratio (C/Si) and the atomic weight ratio (O/Si) to be within the above-described ranges include a method of applying a siloxane compound including the D unit, the T unit, and the Q unit in appropriate ranges, which will be described later.

The atomic weight ratio (C/Si) and the atomic weight ratio (O/Si) are measured using an X-ray photoelectron spectrometer "JPS-9030" manufactured by JEOL Ltd. Specifically, the measurement is performed as follows.

In the X-ray photoelectron spectrometer, under conditions of an acceleration voltage of 10 [kV] and an emission current of 20 [mA], MgKα rays having a photon energy of 1253.6 [eV] are generated, and a sample of the siloxane compound film to be measured is irradiated with X-rays.

As a result, a wide spectrum is acquired.

Next, an area ratio of the spectrum of each element of Si, O, and C is obtained using "XPS analysis software SpecSurf" attached to the X-ray photoelectron spectrometer "JPS-9030" manufactured by JEOL Ltd.

On the other hand, the area ratio of the spectrum of each element of Si, O, and C is obtained for a sample having known atomic weights of Si, O, and C in the same manner.

Next, atomic weights (atom%) of Si, O, and C in the sample of the siloxane compound film to be measured are quantified from the area ratio of the spectrum of each element, and the atomic weight ratio (C/Si) and the atomic weight ratio (O/Si) are obtained.

The siloxane compound film according to the present exemplary embodiment may be a film containing the siloxane compound as the principal component (for example, a matrix material that is a binding material), or may be a film containing a binding resin and the siloxane compound. The siloxane compound film may contain other additives.

Here, the film containing the siloxane compound as the principal component (for example, a matrix material that is to be a binding material) refers to a layer containing only the siloxane compound or a layer having the highest amount of the siloxane compound.

### -Siloxane Compound-

For example, the siloxane compound preferably has a D unit (oxidation valence of Si: 2) that imparts flexibility, a T unit (oxidation valence of Si: 3) that imparts release properties, and a Q unit (oxidation valence of Si: 4) that imparts abrasion resistance.

Here, the D unit is a D unit represented by a formula: (R^{D1}R^{D2}SiO_{2/2})_{nd}. Here, in the D unit, R^{D1} and R^{D2} are organic groups, nd is an integer of 2 or more, and at least one of R^{D1} or R^{D2} among a plurality of R^{D1}'s and R^{D2}'s present in the D unit is a group including at least one of an alkyl group or an aryl group.

The T unit is a T unit represented by a formula: [R^{T1}SiO_{3/2}]ₙᵣ, where, in the T unit, R^{T1} is an organic group, nt is an integer of 2 or more, and at least one of R^{T1} among a plurality of R^{T1}'s present in the T unit is a group including at least one of an alkyl group or an aryl group.

The Q unit is a Q unit represented by a formula: [SiO_{4/2}]_{nq}, where, in the Q unit, nq is an integer of 2 or more.

In the D unit and the T unit, the organic group of R^{D1}, R^{D2}, and R^{T1} in the formulae represents, for example, a hydroxyl group, a siloxy group, a hydrocarbon group, a hydrocarbon group in which one or a plurality of methylene groups are replaced with a carbonyl group, a hydrocarbon group in which one or a plurality of carbon atoms are replaced with a heteroatom (an oxygen atom, a nitrogen atom, or a sulfur atom), or a group obtained by combining these groups.

Examples of the siloxy group described as the organic group represented by R^{D1}, R^{D2}, and R^{T1} include a monoalkylsiloxy group, a dialkylsiloxy group, and a trialkylsiloxy group; and for example, a dialkylsiloxy group or a trialkylsiloxy group is preferable, and a trialkylsiloxy group is more preferable.

Examples of the hydrocarbon group described as the organic group represented by R^{D1}, R^{D2}, and R^{T1} include an aliphatic hydrocarbon group and an aromatic hydrocarbon group.

Examples of the aliphatic hydrocarbon group include a linear, branched, or alicyclic saturated aliphatic hydrocarbon group, and a linear, branched, or alicyclic unsaturated aliphatic hydrocarbon group.

The aliphatic hydrocarbon group is, for example, preferably a hydrocarbon group having 1 or more and 20 or less carbon atoms, and more preferably a hydrocarbon group having 1 or more and 15 or less carbon atoms.

The aliphatic hydrocarbon group may be substituted with a substituent such as a halogen atom, a hydroxyl group, an amino group, and an aryl group.

Examples of the aromatic hydrocarbon group include a hydrocarbon group having 6 or more and 18 or less carbon atoms (for example, preferably 6 or more and 14 or less carbon atoms). Examples of the aromatic hydrocarbon group include a phenyl group, a naphthyl group, and an anthracenyl group.

The aromatic hydrocarbon group may be substituted with a substituent such as a halogen atom, a hydroxyl group, an amino group, an alkyl group, and an alkoxy group.

The organic group represented by R^{D1}, R^{D2}, and R^{T1} may have a reactive group. Examples of the reactive group include a vinyl group, an allyl group, a styryl group, a maleimide group, an epoxy group, an oxetanyl group, and a (meth)acryloyl group. That is, the polysiloxane compound may be cured particles in which the above-described reactive group is reacted.

A plurality of R^{D1}'s, R^{D2}'s, and R^{T1}'s present in the T unit and the D unit may be the same organic group or different organic groups.

However, at least one R^{D1} or R^{D2} among the plurality of R^{D1}'s and R^{D2}'s present in the D unit is, for example, preferably a group including at least one of an alkyl group or an aryl group.

That is, for example, it is preferable that at least one R^{D1} among the plurality of R^{D1}'s present in the D unit is a group including at least one of an alkyl group or an aryl group. For example, it is preferable that at least one R^{D2} among the plurality of R^{D2}'s present in the D unit is a group including at least one of an alkyl group or an aryl group.

For example, it is preferable that at least one R^{T1} among the plurality of R^{T1}'s present in the T unit is a group including at least one of an alkyl group or an aryl group.

Here, from the viewpoint of improving the release properties, as the group including an alkyl group, for example, an alkyl group itself or a siloxy group including an alkyl group is preferable. That is, at least one of a plurality of R's present in the structure A is, for example, preferably an alkyl group or a siloxy group containing an alkyl group.

From the viewpoint of improving the release properties, the alkyl group is, for example, preferably an alkyl group having 1 or more and 6 or less carbon atoms, and more preferably an alkyl group having 1 or more and 4 or less carbon atoms or an alkyl group having 1 carbon atom (that is, a methyl group).

As the group including an aryl group, for example, an aryl group itself or an aralkyl group is preferable.

Examples of the aryl group include a phenyl group and a naphthyl group.

Examples of an alkyl group in the aralkyl group include an alkyl group with a linear or branched alkyl chain having 1 or more and 4 or less carbon atoms. Examples of an aryl group in the aralkyl group include a phenyl group and a naphthyl group. Examples of the aralkyl group include a benzyl group, a 1-phenylethyl group, a 2-phenylethyl group, and a 2-methyl-2-phenylethyl group.

From the viewpoint of improving the release properties, as the group including an aryl group, for example, a phenyl group is preferable.

From the viewpoint of improving the release characteristics, a presence proportion of the group including at least one of an alkyl group or an aryl group with respect to the polysiloxane compound is, for example, preferably 10 mol% or more and 50 mol% or less and more preferably 25 mol% or more and 50 mol% or less.

The presence proportion of the group including at least one of an alkyl group or an aryl group can be measured by liquid-state nuclear magnetic resonance (NMR) or solid-state NMR.

In the D unit, the T unit, and the Q unit, nd, nt, and nq in the formulae represent an integer of 2 or more.

In the D unit, the T unit, and the Q unit, nd/nt is, for example, preferably 0.1 or more and 10 or less, and more preferably 0.25 or more and 4.0 or less.

nq/nt is, for example, preferably 0.010 or more and 2.0 or less, and more preferably 0.012 or more and 1.0 or less.

In a case where nd, nt, and nq are in the ranges of the ratios described above, the half-value width of the peak is controlled in the above-described range, and thus the release properties, the abrasion resistance, and the flexibility are easily improved.

A content of the siloxane compound with respect to the surface layer is, for example, preferably 50% by volume or more and 100% by volume or less, more preferably 75% by volume or more and 100% by volume or less, and still more preferably 90% by volume or more and 100% by volume or less.

Examples of the siloxane compound include a polymer compound referred to as silsesquioxane (SQ) having various skeleton structures.

The polysiloxane compound may have, as a skeleton structure, any of a cage-type structure (a perfect cage-type structure or a cage-type structure), a ladder-type structure, or a random structure.

### -Binding Material-

Examples of the binding material include a polyamide resin, a polyurethane resin, a polyvinylidene fluoride resin, a tetrafluoroethylene copolymer resin, a polyester resin, a polyimide resin, a silicone resin, an acrylic resin, a polyvinyl butyral resin, an ethylene tetrafluoroethylene copolymer resin, a melamine resin, a fluororubber, an epoxy resin, a polycarbonate resin, a polyvinyl alcohol resin, a cellulose resin, a polyvinylidene chloride resin, a polyvinyl chloride resin, a polyethylene resin, and an ethylene vinyl acetate copolymer resin.

In particular, as the binding material, for example, a urethane resin is preferable. The urethane resin may be an acrylic urethane resin, a polyester polyurethane resin, a polyether polyurethane resin, or the like. Among these, as the urethane resin, for example, a silicone-modified urethane resin is preferable, and a silicone-modified acrylic urethane resin is more preferable.

A content of the binding material is an amount of the principal component of the siloxane compound film. Here, the amount of the principal component of the siloxane compound film means an amount of the most abundant component among the components contained in the siloxane compound film, excluding the siloxane compound.

### (Other Additives)

The siloxane compound film may be compounded with other additives. Examples of the additive include a conductive agent, a filler, a softener (paraffin-based softener and the like), a processing aid (stearic acid and the like), and an aging inhibitor (amine-based aging inhibitor and the like).

A film thickness of the siloxane compound film is, for example, preferably 10 µm or more and 100 µm or less, and more preferably 20 µm or more and 50 µm or less.

### <Method of Manufacturing Siloxane Compound Film>

Examples of the method of manufacturing the siloxane compound film according to the present exemplary embodiment include a method of forming the siloxane compound film by plasma enhanced chemical vapor deposition (plasma CVD) using a raw material siloxane compound as a raw material.

In the plasma CVD, direct current power or alternating current power can be used as an excitation unit for activating and decomposing the raw material siloxane compound. As the alternating current power, a microwave, a radio wave, or the like can be used.

By adjusting an output of the direct current power, an output of the alternating current power, or a frequency of the alternating current power, the excitation state and the reaction atmosphere can be controlled, so that the formulation or the bonding state of the obtained siloxane compound film can be controlled.

That is, by adjusting the output of the direct current power, the output of the alternating current power, or the frequency of the alternating current power, the siloxane compound film satisfying the above-described peak characteristics, the above-described atomic weight ratio (C/Si), and the above-described atomic weight ratio (O/Si) can be obtained.

Examples of the raw material siloxane compound include "siloxane compound consisting of a siloxane bond and an organic group" such as alkyl disiloxanes (hexamethyldisiloxane and the like) and alkyl cyclosiloxanes (octamethylcyclo-tetrasiloxane, decamethylcyclopentasiloxane, dodecamethylcyclohexasiloxane, and the like).

From the viewpoint of introducing an alkyl group (particularly, a methyl group) into the obtained siloxane compound film to improve the release properties, the raw material siloxane compound is, for example, preferably a compound having an alkyl group (particularly, a methyl group), such as the above-described exemplified compounds.

By exciting, decomposing, and reacting the raw material siloxane compound in a plasma atmosphere, the target siloxane compound film can be formed.

Examples of a supply gas other than the raw material siloxane compound include an inert gas (argon gas, helium gas, and the like), H₂ gas, N₂ gas, O₂ gas, and a low-molecular-weight hydrocarbon gas (CH₄ gas, C₂H₂ gas, C₆H₆ gas, and the like).

By supplying the inert gas (argon gas, helium gas, and the like) together with the raw material siloxane compound, the excitation state and the reaction atmosphere can be controlled, so that the formulation or the bonding state of the obtained film can be controlled.

By supplying the H₂ gas, the N₂ gas, the O₂ gas, or the low-molecular-weight hydrocarbon gas (CH₄ gas, C₂H₂ gas, C₆H₆ gas, and the like) together with the raw material siloxane compound, the excitation state and the reaction atmosphere can be controlled, or the elements of these gases can be incorporated into the film, so that the formulation or the bonding state of the obtained siloxane compound film can be controlled.

That is, by changing the type or the supply amount of the supply gas, the siloxane compound film satisfying the above-described peak characteristics, the above-described atomic weight ratio (C/Si), and the above-described atomic weight ratio (O/Si) can be obtained.

Hereinafter, the method of manufacturing the siloxane compound film according to the present exemplary embodiment will be described with reference to drawings and specific examples, with an example of a film forming device using plasma CVD.

In the following description, an aspect in which the siloxane compound film is directly formed on the base material is shown, but the present invention is not limited thereto. For example, the siloxane compound film may be formed on a base material on which an elastic layer or the like has been provided, instead of the base material.

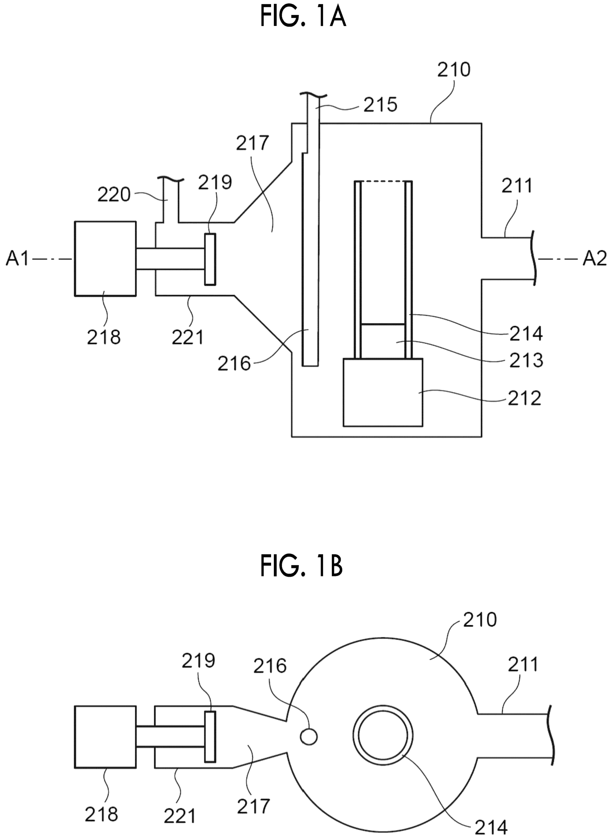

FIGS. 1A and 1B are views schematically showing a configuration of an example of a film forming device used for forming the siloxane compound film according to the present exemplary embodiment. FIG. 1A is a schematic cross-sectional view of the film forming device as viewed from a side. FIG. 1B is a schematic cross-sectional view of the film forming device shown in FIG. 1A between A1 and A2.

In FIGS. 1A and 1B, the reference numeral 210 represents a film forming chamber, the reference numeral 211 represents an exhaust port, the reference numeral 212 represents a base material rotating portion, the reference numeral 213 represents a base material support member, the reference numeral 214 represents a base material, the reference numeral 215 represents a gas introduction pipe, the reference numeral 216 represents a shower nozzle having an opening for injecting gas introduced from the gas introduction pipe 215, the reference numeral 217 represents a plasma diffusion portion, the reference numeral 218 represents a high-frequency power supply portion, the reference numeral 219 represents a flat plate electrode, the reference numeral 220 represents a gas introduction pipe, and the reference numeral 221 represents a high-frequency discharge tube portion.

In the film forming device shown in FIGS. 1A and 1B, the exhaust port 211 connected to a vacuum exhaust device (not shown) is provided at one end of the film forming chamber 210. A plasma generation device consisting of the high-frequency power supply portion 218, the flat plate electrode 219, and the high-frequency discharge pipe portion 221 is provided on a side of the film forming chamber 210 opposite to a side on which the exhaust port 211 is provided.

In the plasma generation device, the high-frequency power supply portion 218 is connected to a surface of the flat plate electrode 219 opposite to a discharge surface, outside the high-frequency discharge pipe portion 221. The flat plate electrode 219 is disposed in the high-frequency discharge pipe portion 221 such that the discharge surface faces the exhaust port 211 side.

A gas introduction pipe 220 for supplying a gas into the high-frequency discharge pipe portion 221 is connected to the high-frequency discharge pipe portion 221. The other end of the gas introduction pipe 220 is connected to a first gas supply source (not shown).

A rod-shaped shower nozzle 216 that extends along the discharge surface is connected to the discharge surface side of the flat plate electrode 219, and one end of the shower nozzle 216 is connected to the gas introduction pipe 215. The gas introduction pipe 215 is connected to a second gas supply source (not shown) provided outside the film forming chamber 210.

The base material rotating portion 212 is provided in the film forming chamber 210. A cylindrical base material 214 is attached to the base material rotating portion 212 through the base material support member 213 such that the shower nozzle 216 in the longitudinal direction and the base material 214 in the axial direction face each other.

In the film formation, the base material 214 rotates in the circumferential direction along with the rotation of the base material rotating portion 212.

The siloxane compound film is formed, for example, as follows.

First, a supply gas other than the raw material siloxane compound (an inert gas, H₂ gas, N₂ gas, O₂ gas, or a low-molecular-weight hydrocarbon gas) is introduced from the gas introduction pipe 220 into the high-frequency discharge pipe portion 221, and a radio wave as alternating current power is supplied from the high-frequency power supply portion 218 to the flat plate electrode 219. In this case, the plasma diffusion portion 217 is formed such that the plasma diffusion unit radially extends from the discharge surface side of the flat plate electrode 219 to the exhaust port 211 side. Here, the supply gas introduced from the gas introduction pipe 220 flows through the film forming chamber 210 from the flat plate electrode 219 side to the exhaust port 211 side. The flat plate electrode 219 may be formed such that the electrode is surrounded by a ground shield.

Next, the raw material siloxane compound is introduced into the film forming chamber 210 through the shower nozzle 216 positioned downstream of the flat plate electrode 219, that is an activation device, from the gas introduction pipe 215. As a result, the target siloxane compound film is formed on the surface of the base material 214.

Since the base material 214 (or a layer provided on the base material 214) may be damaged by heat, for example, it is preferable to control the surface temperature of the base material 214 in consideration of the influence.

The temperature of the surface of the base material 214 may be controlled by at least one of a heating device or a cooling device (not shown in the drawing) or may be controlled by a natural increase in temperature during discharging.

In a case where the base material 214 is heated, a heater may be installed on the outside or inside of the base material 214. In a case where the base material 214 is cooled, gas or a liquid for cooling may be circulated inside the base material 214.

In a case where an increase in the temperature of the surface of the base material 214 due to discharge is intended to be avoided, it is effective to adjust the high-energy gas flow coming into contact with the surface of the base material 214. In this case, the conditions such as the gas flow rate, the discharge output, and the pressure are adjusted to obtain a required temperature.

The plasma generation device of the film forming device shown in FIGS. 1A and 1B uses a high-frequency oscillation device, but the present invention is not limited thereto, and for example, a microwave oscillation device or an electrocyclotron resonance type or a helicon plasma type device may be used. In addition, in a case of a high-frequency oscillation device, an inductive type or a capacitive type may be used.

Furthermore, two or more kinds of these devices may be used in combination, or two or more of the same devices may be used. In order to suppress an increase in the temperature of the surface of the base material 214 due to irradiation with plasma, for example, a high-frequency oscillation device is preferable, but a device that suppresses irradiation with heat may be provided.

In a case where two or more different kinds of plasma generation devices are used, for example, it is preferable that discharge occurs simultaneously at the same pressure in the plasma generation devices. In addition, a pressure difference may be provided between a region of discharge and a region of film formation (portion where the base material 214 is installed). These devices may be arranged in series with respect to the gas flow formed in the film forming device from the portion where the gas is introduced to the portion where the gas is discharged, or all the devices may be arranged to face the film forming surface of the base material.

As film forming conditions of the siloxane compound film satisfying the above-described peak characteristics, the above-described atomic weight ratio (C/Si), and the above-described atomic weight ratio (O/Si), in a case where the plasma CVD is performed by high-frequency discharge, for example, the following conditions are preferable.
· Temperature of surface of base material 214 during film formation: 10°C or higher and 300°C or lower
· Reaction pressure in film forming chamber 210: 1 Pa or more and 110,000 Pa or less
· Frequency of radio wave as alternating current power: 100 kHz or more and 10 GHz or less
· Output of radio wave as alternating current power: 10 W or more and 5000 W or less
· Rotation speed of base material 214: 0.1 rpm or more and 100 rpm or less

The method of manufacturing the siloxane compound film according to the present exemplary embodiment is not limited to a film forming method by the plasma CVD.

Examples of the method of manufacturing the siloxane compound film according to the present exemplary embodiment also include a method of baking a coating film of a mixture of a silicone material (dimethylsiloxane, silsesquioxane, and the like) and silica particles.

Examples of a commercially available product of the silicone material to be used include "DOWSIL series" manufactured by Dow Chemical Company.

### <Member>

The member according to the present exemplary embodiment is a member including a base material and a surface layer that is provided on the base material and is constituted of the siloxane compound film according to the present exemplary embodiment described above.

The surface layer constituted of the siloxane compound film according to the present exemplary embodiment described above is a layer constituting the outermost layer of the member.

The member according to the present exemplary embodiment may include a layer (for example, an elastic layer provided between the base material and the siloxane compound film) other than the base material and the siloxane compound film.

The member according to the present exemplary embodiment may be cylindrical or may be an endless belt shape.

### (Base Material)

Examples of the base material include a cylindrical base material formed of a metal (aluminum, SUS, iron, copper, or the like), an alloy, ceramics, a fiber-reinforced metal (FRM), or the like.

An outer diameter and a thickness of the cylindrical base material may be, for example, an outer diameter of 10 mm or more and 50 mm or less. In a case of the aluminum cylindrical base material, the thickness may be, for example, 0.5 mm or more and 4 mm or less; and in a case of the SUS (stainless steel) cylindrical base material or the iron cylindrical base material, the thickness may be, for example, 0.1 mm or more and 2 mm or less.

Examples of the base material also include a metal belt and a resin belt.

Examples of the metal belt include a metal belt formed of nickel, aluminum, stainless steel, or the like.

Examples of the resin belt include a heat-resistant resin belt formed of polyimide, polyamideimide, polyphenylene sulfide, polyether ether ketone, polybenzimidazole, or the like.

The resin belt may contain a conductive powder or the like in order to control a volume resistivity. Specifically, examples of the resin belt include a polyimide resin belt in which carbon black is added and dispersed. In addition, examples of the belt also include a belt formed by combining both ends of a long polyimide sheet in a puzzle shape and performing thermocompression using a thermocompression member to obtain a belt-shaped product.

Here, as the base material, for example, a metal base material (that is, a base material made of the above-described metal, a metal belt, and the like) may be applied. Even in a case of the metal base material, in a case where the siloxane compound film is directly formed on the metal base material by the plasma CVD, adhesiveness between the metal base material and the siloxane compound film is improved.

A thickness of the belt base material is, for example, preferably 20 µm or more and 200 µm or less, more preferably 30 µm or more and 150 µm or less, and still more preferably 40 µm or more and 130 µm or less.

A metal layer may be provided on the base material as necessary. In a case where the metal layer is provided, the metal layer may be formed in a single layer or may be formed in multiple layers. The metal layer formed in a single layer may be an electromagnetic induction metal layer that generates heat by electromagnetic induction. In addition, the metal layer formed in multiple layers may be formed in a three-layer structure of, for example, an underlayer metal layer, an electromagnetic induction metal layer, and a metal protective layer.

An adhesive may be applied onto a surface of the base material. That is, the adhesive is used as necessary, and the base material (or the metal layer on the base material) and the elastic layer or the surface layer may be laminated with the adhesive interposed therebetween. The adhesive is not particularly limited, and examples thereof include an adhesive compound having a hydrogen-bonding silyl group (-SiH) in which a hydrogen atom is bonded.

### [Elastic Layer]

For example, it is preferable that the elastic layer is a layer that is restored to an original shape even though deformation occurs due to external force application of 100 Pa.

Examples of an elastic material constituting the elastic layer include isoprene rubber, chloroprene rubber, epichlorohydrin rubber, butyl rubber, polyurethane rubber, silicone rubber, fluororubber, styrene-butadiene rubber, butadiene rubber, nitrile rubber, ethylene-propylene rubber, epichlorohydrin-ethylene oxide copolymer rubber, epichlorohydrin-ethylene oxide-allyl glycidyl ether copolymer rubber, ethylene-propylene-diene terpolymer rubber (EPDM), acrylonitrile-butadiene copolymer rubber (NBR), natural rubber, and blended rubber thereof.

Among these, from the viewpoint of heat resistance, thermal conductivity, insulation, and the like, the elastic material is, for example, more preferably silicone rubber.

Examples of the silicone rubber include RTV silicone rubber, HTV silicone rubber, and liquid silicone rubber; and specific examples thereof include polydimethyl silicone rubber (MQ), methyl vinyl silicone rubber (VMQ), methyl phenyl silicone rubber (PMQ), and fluorosilicone rubber (FVMQ).

As the silicone rubber, for example, silicone rubber that is crosslinked generally by an addition reaction is preferable. In addition, various types of functional groups are known for silicone rubber, and for example, dimethyl silicone rubber having a methyl group, methyl phenyl silicone rubber having a methyl group and a phenyl group, vinyl silicone rubber having a vinyl group (vinyl group-containing silicone rubber), or the like is preferable.

Furthermore, as the silicone rubber, for example, vinyl silicone rubber having a vinyl group is more preferable, and silicone rubber that has an organopolysiloxane structure having a vinyl group and a hydrogen organopolysiloxane structure having a hydrogen atom bonded to a silicon atom (SiH) is still more preferable.

The elastic layer may be a foamed elastic layer or a non-foamed elastic layer.

The elastic layer may contain other additives. Examples of the other additives include a filler, a softener (paraffin-based softener and the like), a processing aid (stearic acid and the like), an aging inhibitor (amine-based aging inhibitor and the like), and a vulcanizing agent (sulfur, a metal oxide, a peroxide, and the like).

A film thickness of the elastic layer is, for example, preferably 30 µm or more and 600 µm or less, and more preferably 100 µm or more and 500 µm or less.

### (Application of Member)

Examples of the member according to the present exemplary embodiment include a transfer member, a fixing member, a recording medium transport member, and the like for electrophotography.

Examples of the transfer member include an intermediate transfer member, a primary transfer member, and a secondary transfer member.

Examples of the fixing member include a heating member and a pressurizing member. The heating member may be any of a heating belt heated by an electromagnetic induction method or a heating member heated from an external heat source.

However, in a case where the member according to the present exemplary embodiment is applied to the heating member heated by an electromagnetic induction method, for example, a metal layer (heat generation layer) that generates heat by electromagnetic induction may be provided.

In addition, examples of the member according to the present exemplary embodiment also include a cooking utensil such as a frying pan. In this case, the base material corresponds to a body of the "cooking utensil such as a frying pan", that is a target on which the siloxane compound film according to the present exemplary embodiment is formed as a surface layer.

That is, examples of the application of the siloxane compound film according to the present exemplary embodiment include the surface layer for the above-described exemplified member.

### <Fixing Device>

The fixing device according to the present exemplary embodiment includes a first rotating body and a second rotating body disposed in contact with an outer surface of the first rotary member, in which at least one of the first rotating body or the second rotating body is constituted of the member according to the present exemplary embodiment described above.

Hereinafter, the fixing device according to the present exemplary embodiment will be described with reference to a fixing device having an aspect of including a heating roll (an example of the first rotating body) and a pressurizing belt (an example of the second rotating body).

The fixing device according to the present exemplary embodiment is not limited to the above-described aspect, and may be a fixing device including a heating roll and a pressurizing roll, a fixing device including a heating belt and a pressurizing roll, or a fixing device including a heating belt and a pressurizing belt.

In the fixing device according to the present exemplary embodiment, the fixing member according to the present exemplary embodiment described above may be applied to any of the heating roll, the heating belt, the pressurizing roll, or the pressurizing belt.

As the fixing device according to the present exemplary embodiment, a well-known fixing device such as an electromagnetic induction heating method can be applied.

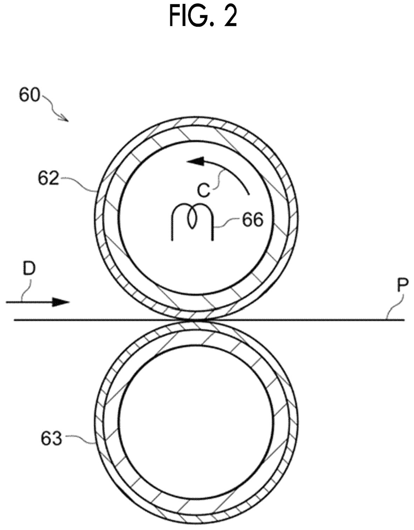

FIG. 2 is a view schematically showing a configuration of an example of the fixing device according to the present exemplary embodiment.

A fixing device 60 shown in FIG. 2 includes a heating roll 62 (an example of the heating member) and a pressurizing roll 63 (an example of the pressurizing member).

A heating source 66 that heats the heating roll 62 is provided inside the heating roll 62.

In the fixing device 60, the heating roll 62 and the pressurizing roll 63 are disposed to be freely rotatable. The heating roll 62 is connected to a drive source (for example, a motor; not shown) through a power transmission member (a gear or the like; not shown). The power generated by the drive source (for example, a motor) is transmitted to the heating roll 62 by the power transmission member (a gear or the like). As a result, the heating roll 62 is rotationally driven in a direction of an arrow C.

The pressurizing roll 63 is disposed to be pressed against the heating roll 62 by a spring or the like (not shown). The pressurizing roll 63 is rotationally driven in response to the rotation drive of the heating roll.

In the fixing device 60, paper (an example of the recording medium) P on which an unfixed toner image is transferred enters a contact portion between the heating roll 62 heated by the heating source 66 and the pressurizing roll 63 by a transport mechanism (not shown).

As the paper P is transported in a direction of an arrow D, the toner image transferred to the paper P is heated and pressurized at the contact portion between the heating roll 62 and the pressurizing roll 63. As a result, the toner image is fixed to the paper P.

### <Image Forming Apparatus>

Next, the image forming apparatus according to the present exemplary embodiment will be described.

The image forming apparatus according to the present exemplary embodiment includes:
an image holder;
a charging device that charges a surface of the image holder;
an electrostatic latent image forming device that forms an electrostatic latent image on the charged surface of the image holder;
a developing device that accommodates a developer containing a toner and develops the electrostatic latent image formed on the surface of the image holder with the developer to form a toner image;
a transfer device that transfers the toner image onto a surface of a recording medium; and
the fixing device that fixes the toner image on the surface of the recording medium.

As the fixing device, the fixing device according to the present exemplary embodiment is applied.

In the image forming apparatus according to the present exemplary embodiment, the fixing device may be made into each cartridge such that the fixing device is detachable from an image forming apparatus. That is, the image forming apparatus according to the present exemplary embodiment may include the fixing device according to the present exemplary embodiment, as a device configuring a process cartridge.

Hereinafter, the image forming apparatus according to the present exemplary embodiment will be described with reference to a drawing.

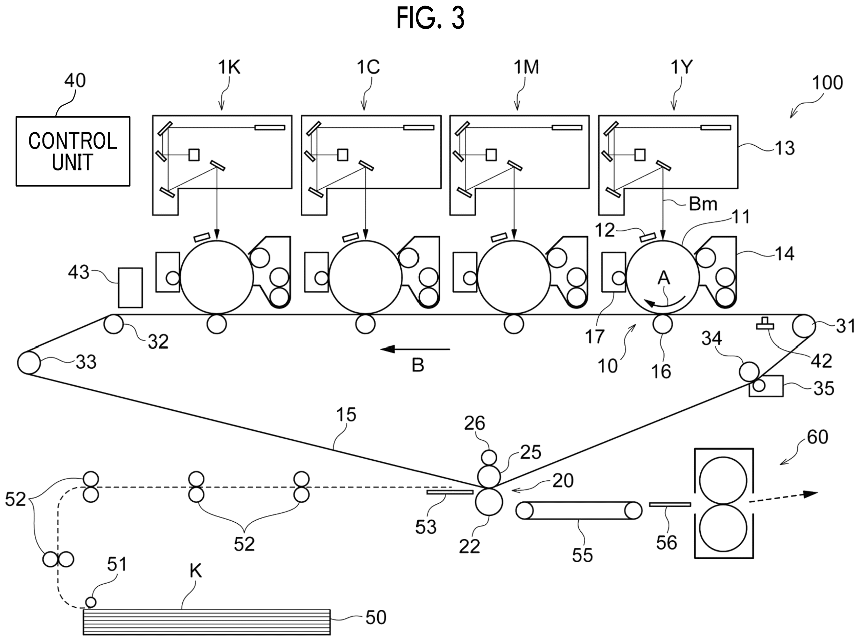

FIG. 3 is a schematic configuration view showing a configuration of the image forming apparatus according to the present exemplary embodiment.

As shown in FIG. 3, an image forming apparatus 100 according to the present exemplary embodiment is, for example, an intermediate transfer-type image forming apparatus generally called a tandem type.

The image forming apparatus 100 includes a plurality of image forming units 1Y, 1M, 1C, and 1K, an intermediate transfer belt 15, a primary transfer unit 10, a secondary transfer unit 20, and the fixing device 60. In addition, the image forming apparatus 100 includes a control unit 40 that controls the operation of each device (or each unit).

Here, the image forming units 1Y, 1M, 1C, and 1K are image forming units that form a toner image of each color component by an electrophotographic method.

The primary transfer unit 10 is a transfer unit that sequentially transfers (primary transfers) the toner image of each color component formed by the image forming units 1Y, 1M, 1C, and 1K to the intermediate transfer belt 15.

The secondary transfer unit 20 is a transfer unit that collectively transfers (secondary transfers) the superimposed toner images transferred to the intermediate transfer belt 15 to the paper K that is the recording medium.

The fixing device 60 is a device that fixes the image transferred by the secondary transfer to the paper K.

Each of the image forming units 1Y, 1M, 1C, and 1K of the image forming apparatus 100 includes a photoreceptor 11 that rotates in a direction of an arrow A, as an example of an image holder that holds a toner image formed on the surface.

Around the photoreceptor 11, a charger 12 that charges the photoreceptor 11 is provided as an example of the charging device. Around the photoreceptor 11, a laser exposure device 13 (exposure beam is indicated by a reference numeral Bm in the drawing) that writes an electrostatic latent image on the photoreceptor 11 is provided as an example of the electrostatic latent image forming device.

Around the photoreceptor 11, a developer 14 that accommodates the toner of each color component and visualizes the electrostatic latent image on the photoreceptor 11 with the toner is provided as an example of the developing device.

Around the photoreceptor 11, a primary transfer roll 16 that transfers the toner image of each color component formed on the photoreceptor 11 to the intermediate transfer belt 15 by the primary transfer unit 10 is provided.

Around the photoreceptor 11, a photoreceptor cleaner 17 that removes a residual toner on the photoreceptor 11 is provided.

The charger 12, the laser exposure device 13, the developer 14, the primary transfer roll 16, and the photoreceptor cleaner 17 are sequentially arranged around the photoreceptor 11 along the rotation direction of the photoreceptor 11.

These image forming units 1Y, 1M, 1C, and 1K are substantially linearly arranged in order of yellow (Y), magenta (M), cyan (C), and black (K) from the upstream side of the intermediate transfer belt 15.

By various rolls, the intermediate transfer belt 15 is driven to circulate (rotate) in the direction of an arrow B shown in FIG. 2 at a speed fit for the purpose.

The various rolls include a drive roll 31, a support roll 32, a tension applying roll 33, a back roll 25, and a cleaning back roll 34.

The drive roll 31 is a roll that is driven by a motor (not shown) having an excellent constant speed property and rotates the intermediate transfer belt 15.

The support roll 32 is a roll that supports the intermediate transfer belt 15 extending in a substantially linear shape along the arrangement direction of each photoreceptor 11.

The tension applying roll 33 is a roll that is provided in the secondary transfer unit 20, has a function of applying a tension to the intermediate transfer belt 15, and prevents the intermediate transfer belt 15 from meandering.

The cleaning back roll 34 is a roll that is provided in a cleaning portion that scrapes off the residual toner on the intermediate transfer belt 15.

The primary transfer unit 10 is configured with the primary transfer roll 16 that is disposed to face the photoreceptor 11 across the intermediate transfer belt 15.

The primary transfer roll 16 is disposed to be pressed against the photoreceptor 11 with the intermediate transfer belt 15 therebetween, and a voltage with a polarity (primary transfer bias) opposite to the charging polarity (negative polarity; the same applies hereafter) of the toner is applied to the primary transfer roll 16. As a result, the toner image on each photoreceptor 11 is sequentially electrostatically sucked onto the intermediate transfer belt 15, which leads to the formation of overlapped toner images on the intermediate transfer belt 15.

The secondary transfer unit 20 is configured to include the back roll 25 and a secondary transfer roll 22 that is disposed on a toner image-holding surface side of the intermediate transfer belt 15.

The secondary transfer roll 22 is disposed to be pressed on the back roll 25 across the intermediate transfer belt 15, and the secondary transfer roll 22 is grounded such that the secondary transfer bias is formed between the secondary transfer roll 22 and the back roll 25, that induces secondary transfer of the toner image onto the paper K transported to the secondary transfer unit 20.

In addition, an intermediate transfer belt cleaner 35 is provided on the downstream side of the secondary transfer unit 20 on the intermediate transfer belt 15 to be freely attachable to and detachable from the intermediate transfer belt 15.

The intermediate transfer belt cleaner 35 is a cleaner that removes the residual toner or paper powder on the intermediate transfer belt 15 after the secondary transfer, and cleans the surface of the intermediate transfer belt 15.

The intermediate transfer belt 15, the primary transfer unit 10 (primary transfer roll 16), and the secondary transfer unit 20 (secondary transfer roll 22) correspond to an example of the transfer device.

On the other hand, a reference sensor (home position sensor) 42 is disposed on an upstream side of the yellow image forming unit 1Y.

The reference sensor 42 is a sensor that generates a reference signal serving as a reference for taking an image forming timing in each of the image forming units 1Y, 1M, 1C, and 1K.

The reference sensor 42 recognizes a mark provided on a back side of the intermediate transfer belt 15 to generate the reference signal. Each of the image forming units 1Y, 1M, 1C, and 1K is configured to start the image formation in response to an instruction from the control unit 40 based on the recognition of the reference signal.

An image density sensor 43 used to adjust image quality is provided on the downstream side of the black image forming unit 1K.

The image forming apparatus 100 includes a paper storage portion 50, a paper feeding roll 51, a transport roll 52, a transport guide 53, a transport belt 55, and a fixing inlet guide 56.

The paper storage portion 50 is a storage unit that accommodates the paper K, as a transport device that transports the paper K.

The paper feeding roll 51 is a roll that takes out the paper K accumulated in the paper storage portion 50 at a predetermined timing, and transports the paper K.

The transport roll 52 is a roll that transports the paper K fed by the paper feeding roll 51.

The transport guide 53 is a guide that feeds the paper K transported by the transport roll 52 to the secondary transfer unit 20.

The transport belt 55 is a belt that transports the paper K, that is secondarily transferred by the secondary transfer roll 22, to the fixing device 60.

The fixing inlet guide 56 is a guide that guides the paper K to the fixing device 60.

Next, basic image forming process of the image forming apparatus 100 according to the present exemplary embodiment will be described.

In the image forming apparatus 100 according to the present exemplary embodiment, image data output from an image reading device (not shown), a personal computer (PC) (not shown), or the like is subjected to image processing by an image processing device (not shown), and then the image forming units 1Y, 1M, 1C, and 1K perform the image forming operation.

In the image processing device, various types of image processing, such as shading correction, misregistration correction, brightness/color space conversion, gamma correction, frame removal or color editing, and movement editing, are performed on input image data. The image data that has been subjected to the image processing is converted into color material gradation data of four colors of yellow (Y), magenta (M), cyan (C), and black (K), and is output to the laser exposure device 13.

In the laser exposure device 13, according to the input color material gradation data, for example, the photoreceptor 11 of each of the image forming units 1Y, 1M, 1C, and 1K is irradiated with an exposure beam Bm emitted from a semiconductor laser. The surface of each of the photoreceptors 11 of the image forming units 1Y, 1M, 1C, and 1K is charged by the charger 12, and is then scanned and exposed by the laser exposure device 13, so that the electrostatic latent image is formed. By each of the image forming units 1Y, 1M, 1C, and 1K, the formed electrostatic latent image is developed as a toner image of each of the colors of yellow (Y), magenta (M), cyan (C), and black (K).

The toner image formed on each of the photoreceptors 11 of the image forming units 1Y, 1M, 1C, and 1K is transferred onto the intermediate transfer belt 15 at the primary transfer unit 10 where each photoreceptor 11 and the intermediate transfer belt 15 are in contact with each other. More specifically, in the primary transfer unit 10, by the primary transfer roll 16, a voltage (primary transfer bias) with a polarity opposite to the charging polarity (negative polarity) of the toner is applied to the base material of the intermediate transfer belt 15, and the toner images are sequentially overlapped on the surface of the intermediate transfer belt 15 and subjected to primary transfer.

After the primary transfer by which the toner images are sequentially transferred to the surface of the intermediate transfer belt 15, the intermediate transfer belt 15 moves, and the toner images are transported to the secondary transfer unit 20. In a case where the toner images are transported to the secondary transfer unit 20, in the transport device, the paper feeding roll 51 rotates in accordance with the timing at which the toner images are transported to the secondary transfer unit 20, and the paper K having the target size is fed from the paper storage portion 50. The paper K fed from the paper feeding roll 51 is transported by the transport roll 52, passes through the transport guide 53, and reaches the secondary transfer unit 20. Before reaching the secondary transfer unit 20, the paper K is temporarily stopped, and a positioning roll (not shown) rotates according to the movement timing of the intermediate transfer belt 15 holding the toner image, so that the position of the paper K is aligned with the position of the toner image.

In the secondary transfer unit 20, through the intermediate transfer belt 15, the secondary transfer roll 22 is pressed on the back roll 25. At this time, the paper K transported at the right timing is interposed between the intermediate transfer belt 15 and the secondary transfer roll 22. At this time, in a case where a voltage (secondary transfer bias) with the same polarity as the charging polarity (negative polarity) of the toner is applied from the power supply roll 26, a transfer electric field is formed between the secondary transfer roll 22 and the back roll 25. In the secondary transfer unit 20 pressed by the secondary transfer roll 22 and the back roll 25, the unfixed toner images held on the intermediate transfer belt 15 are electrostatically transferred onto the paper K in a batch.

Thereafter, the paper K on which the toner image is electrostatically transferred is transported as it is in a state of being peeled off from the intermediate transfer belt 15 by the secondary transfer roll 22. The paper K is transported to the transport belt 55 provided on a downstream side of the secondary transfer roll 22 in the paper transport direction. The transport belt 55 transports the paper K to the fixing device 60 according to the optimum transport speed in the fixing device 60. The unfixed toner images on the paper K transported to the fixing device 60 are fixed on the paper K by being subjected to a fixing treatment by heat and pressure by the fixing device 60. The paper K on which the fixed image is formed is transported to an ejected paper-storing portion (not shown) provided in an output portion of the image forming apparatus 100.

On the other hand, after the transfer to the paper K is completed, the residual toner remaining on the intermediate transfer belt 15 is transported to the cleaning unit with the rotation of the intermediate transfer belt 15. The residual toner is removed from the intermediate transfer belt 15 by the cleaning back roll 34 and the intermediate transfer belt cleaner 35.

Although the present exemplary embodiment has been described, the present exemplary embodiment is not limited to the above-described exemplary embodiments, and various modifications, changes, and ameliorations can be added thereto.

### [Examples]

Hereinafter, the present exemplary embodiment will be described in more detail with reference to Examples, but the present exemplary embodiment is not limited to Examples. In the following description, "part" represents "part by mass" unless otherwise specified.

### <Example 1>

### -Production of Heating Roll-

First, an aluminum cylindrical base material having an outer diameter of 102 mm, a length of 380 mm, and a thickness of 10 mm is prepared.

Next, a surface layer consisting of a siloxane compound film is formed. The siloxane compound film is formed using a film forming device having the configuration shown in FIGS. 1A and 1B.

First, the aluminum cylindrical base material is placed on the base material support member 213 in the film forming chamber 210 of the film forming device, and the film forming chamber 210 is evacuated through the exhaust port 211 until the pressure reaches 1 × 10⁻² Pa.

Next, helium gas (flow rate: 100 sccm) is introduced from the gas introduction pipe 220 into the high-frequency discharge pipe portion 221 provided with the flat plate electrode 219 having a diameter of 85 mm, through a mass flow controller (not shown).

Next, hexamethyldisiloxane (HMDSO) (flow rate: 100 sccm) is introduced from the shower nozzle 216 into the plasma diffusion portion 217 in the film forming chamber 210, through the mass flow controller (not shown) and through the gas introduction pipe 215. In this case, a reaction pressure in the film forming chamber 210 measured by a Baratron vacuum gauge is adjusted to 10 Pa by a conductance valve (not shown).

The high-frequency power supply portion 218 and a matching circuit (not shown in FIGS. 1A and 1B) set the output of the radio wave having a frequency of 13.56 MHz as the alternating current power to 500 W, and discharge is carried out from the flat plate electrode 219 by matching the tuner. A reflected wave at this time is 0 W.

In this state, the film is formed while rotating the base material at a speed of 20 rpm, whereby a surface layer having a film thickness of 20 µm consisting of a siloxane compound film is formed on the surface of the base material.

### -Production of Pressurizing Roll-

First, an aluminum cylindrical base material having an outer diameter of 102 mm, a length of 380 mm, and a thickness of 10 mm is prepared.

Next, an elastic layer having a thickness of 2 mm, consisting of silicone rubber (product name: SE6920-A/B, manufactured by Dow Toray Co., Ltd.), is formed on a surface of the base material.

Next, a surface layer having a film thickness of 20 µm consisting of a siloxane compound film is formed on the surface of the base material with the elastic layer by the film forming device having the configuration shown in FIGS. 1A and 1B, in the same manner as in the production of the heating roll.

Through the above-described operation, the heating roll and the pressurizing roll are obtained.

### <Example 2>

A surface layer is formed in the same manner as in Example 1, except that the following item is changed in the formation of the surface layer of the heating roll and the pressurizing roll in Example 1.
· Changing radio wave as alternating current power to 1000 [W]

### <Example 3>

A surface layer is formed in the same manner as in Example 1, except that the following item is changed in the formation of the surface layer of the heating roll and the pressurizing roll in Example 1.
· Changing radio wave as alternating current power to 750 [W]

### <Example 4>

A surface layer is formed in the same manner as in Example 1, except that the following items are changed in the formation of the surface layer of the heating roll and the pressurizing roll in Example 1.
· Introduction of oxygen gas (flow rate: 5 sccm) from gas introduction pipe 220 into high-frequency discharge pipe portion 221 together with helium gas
· Changing radio wave as alternating current power to 300 [W]

### <Example 5>

10 parts by mass of silica particles (AEROSIL "RX50") are mixed with 90 parts by mass of a silicone material ("DOWSIL MS-4002 Moldable Silicone Part A/B", Dow Chemical Company). The mixture is stirred with a magnetic stirrer for 10 hours. As a result, a coating liquid is obtained.

In the formation of the surface layer of the heating roll and the pressurizing roll in Example 1, the coating liquid is applied onto the base material or the base material with the elastic layer by blade coating. The coating film is baked at 115°C for 20 minutes, and further baked at 230°C for 60 minutes to form a surface layer having a film thickness of 20 µm.

### <Example 6>

A surface layer is formed in the same manner as in Example 1, except that the following items are changed in the formation of the surface layer of the heating roll and the pressurizing roll in Example 1.
· Introduction of oxygen gas (flow rate: 20 sccm) from gas introduction pipe 220 into high-frequency discharge pipe portion 221 together with helium gas
· Changing radio wave as alternating current power to 500 [W]

### <Comparative Example 1>

A silicone material ("DOWSIL MS-4002 Moldable Silicone Part A/B", Dow Chemical Company) is used as a coating liquid.

In the formation of the surface layer of the heating roll and the pressurizing roll in Example 1, the coating liquid is applied onto the base material or the base material with the elastic layer by blade coating. The coating film is baked at 115°C for 20 minutes, and further baked at 230°C for 60 minutes to form a surface layer having a film thickness of 20 µm.

### <Comparative Example 2>

A silicone material ("Silicone KR-242A", Shin-Etsu Chemical Co., Ltd.) is used as a coating liquid.

In the formation of the surface layer of the heating roll and the pressurizing roll in Example 1, the coating liquid is applied onto the base material or the base material with the elastic layer by blade coating. The coating film is baked at 200°C for 60 minutes to form a surface layer having a film thickness of 20 µm.

### <Evaluation of Characteristics>

The following properties of the member of each example are measured by the above-described methods.
· Peak position of spectrum measured by X-ray photoelectron spectroscopy (XPS) in siloxane compound film
· Half-value width of peak
· Atomic weight ratio (C/Si) of C to Si in siloxane compound film

### <Actual Machine Evaluation>

The heating roll and the pressurizing roll of each example are mounted on an evaluation image forming apparatus ("DocuCentre III 7000" manufactured by Fujifilm Business Innovation Corporation) as a heating roll and a pressurizing roll of a fixing device.

The following evaluations are performed by the evaluation image forming apparatus.

### (Release Properties)

The evaluation image forming apparatus outputs 100 images in which a patch having an average image density of 100% is arranged at a paper head portion on A3 paper. Images finally formed on the last three A4 papers output are observed. Occurrence status of an image defect caused by offset in which the toner image adhered to the heating roll is evaluated according to the following evaluation standard.

The evaluation standard is as follows.
A+: no offset is observed.
A: offset is observed only rarely, and the image quality is not affected.
B: offset is observed, that is not noticeable in terms of image quality.
C: offset is observed, that is noticeable in terms of image quality.
D: image cannot be recognized due to the offset.

### (Abrasion Resistance)

The evaluation image forming apparatus outputs 10,000 images having an average image density of 10% on A4 paper.

A film thickness of the surface layer of the heating roll is measured before and after the output of 10,000 sheets, and an abrasion amount is calculated. Evaluation is performed based on the following evaluation standard.
A: amount of decrease in film thickness of the surface layer of the heating roll is 0.1 µm or less.
B: amount of decrease in film thickness of the surface layer of the heating roll is more than 0.1 µm and 1.0 µm or less.
C: amount of decrease in film thickness of the surface layer of the heating roll is more than 1.0 µm.
D: surface layer of the heating roll is partially removed by abrasion.

### (Flexibility)

The evaluation image forming apparatus outputs 10,000 images having an average image density of 10% on A4 paper.

After the output of 10,000 sheets, the presence or absence of a crack and peeling of the surface layer due to the crack in the surface layer of the pressurizing roll is evaluated according to the following evaluation standard.
A: no crack is observed in the surface layer of the pressurizing roll.
B: slight crack is observed in the surface layer of the pressurizing roll, but there is no peeling of the surface layer.
C: crack occurs in the surface layer of the pressurizing roll, and the surface layer is partially peeled off.

**[Table 1]**

| | Peak position | Peak half-value width | Atomic weight [C/Si] | Release properties | Abrasion resistance | Flexibility |
|---|---|---|---|---|---|---|
| Examples 1 | 101.3 | 2.44 | 1.38 | A+ | A | A |
| Examples 2 | 101.1 | 1.85 | 1.22 | A | A | B |
| Examples 3 | 101.2 | 2.13 | 1.30 | A+ | A | A |
| Examples 4 | 101.5 | 2.81 | 1.52 | A+ | A | A |
| Examples 5 | 102.8 | 3.10 | 1.25 | B | B | A |
| Examples 6 | 102.3 | 2.10 | 0.28 | B | A | B |
| Comparative Example 1 | 102.0 | 1.54 | 2.02 | C | C | A |
| Comparative Example 2 | 102.5 | 1.75 | 1.02 | A+ | B | C |

From the above results, it is found that the member of the present example is a member including a siloxane compound film that has release properties and achieves both abrasion resistance and flexibility, as compared with the members of Comparative Examples.

The present exemplary embodiments include the following aspects.
(((1))) A siloxane compound film comprising:
   a siloxane compound including Si, O, C, and H as constituent elements,
   wherein the siloxane compound film has a peak in a range of 100 eV or more and 103 eV or less in a spectrum measured by X-ray photoelectron spectroscopy (XPS), and
   a half-value width of the peak is 1.80 eV or more and 4.00 eV or less.
(((2))) The siloxane compound film according to (((1))),
   wherein the siloxane compound film has an Si-O bond and an Si-R bond (R represents a group including at least one of an alkyl group or a phenyl group).
(3) The siloxane compound film according to (((2))),
   wherein R represents a group including an alkyl group.
(((4))) The siloxane compound film according to any one of (((1))) to (((3))),
   wherein the half-value width of the peak is 2.00 eV or more and 3.00 eV or less.
(((5))) The siloxane compound film according to any one of (((1))) to (((4))),
   wherein an atomic weight ratio (C/Si) of C to Si is 0.30 or more.
(((6))) A member comprising:
   a base material; and
   a surface layer that is provided on the base material and is constituted of the siloxane compound film according to any one of (((1))) to (((5))).
(((7))) The member according to (((6))),
   wherein the base material is a metal base material.
(((8))) A fixing device comprising:
   a first rotating body; and
   a second rotating body disposed in contact with an outer surface of the first rotating body,
   wherein at least one of the first rotating body or the second rotating body is constituted of the member according to (((6))) or (((7))).
(((9))) An image forming apparatus comprising:
   an image holder;
   a charging device that charges a surface of the image holder;
   an electrostatic latent image forming device that forms an electrostatic latent image on the charged surface of the image holder;
   a developing device that accommodates a developer containing a toner and develops the electrostatic latent image formed on the surface of the image holder with the developer to form a toner image;
   a transfer device that transfers the toner image onto a surface of a recording medium; and
   the fixing device according to (((8))), that fixes the toner image on the surface of the recording medium.
(((10))) A method of manufacturing the siloxane compound film according to any one of (((1))) to (((5))), the method comprising:
   forming the siloxane compound film by plasma enhanced chemical vapor deposition (plasma CVD) using a raw material siloxane compound as a raw material.

The effects of the above-described aspects are as follows.

According to (((1))) or (((2))), there is provided a siloxane compound film that has release properties and achieves both abrasion resistance and flexibility, as compared with a case where a half-value width of a peak in a range of 100 eV or more and 103 eV or less in a spectrum measured by X-ray photoelectron spectroscopy (XPS) is less than 1.80 eV or more than 4.00 eV.

According to (((3))), there is provided a siloxane compound film that has release properties and achieves both abrasion resistance and flexibility, as compared with a case where R represents a group including a phenyl group.

According to (((4))), there is provided a siloxane compound film that has release properties and achieves both abrasion resistance and flexibility, as compared with a case where the half-value width of the peak is less than 2.00 eV or more than 3.00 eV.

According to (((5))), there is provided a siloxane compound film that has release properties and achieves both abrasion resistance and flexibility, as compared with a case where the atomic weight ratio (C/Si) is less than 0.30.

According to (((6))), (((7))), (((8))), or (((9))), there is provided a member including a siloxane compound film that has release properties and achieves both abrasion resistance and flexibility, or a fixing device or an image forming apparatus including the member, as compared with a case where a half-value width of a peak in a range of 100 eV or more and 103 eV or less in a spectrum measured by X-ray photoelectron spectroscopy (XPS) is less than 1.80 eV or more than 4.00 eV.

According to (((10))), there is provided a method of manufacturing a siloxane compound film, in which the siloxane compound film that has release properties and achieves both abrasion resistance and flexibility is obtained by plasma CVD, as compared with a case of a method of manufacturing a siloxane compound film in which a half-value width of a peak in a range of 100 eV or more and 103 eV or less in a spectrum measured by X-ray photoelectron spectroscopy (XPS) is less than 1.80 eV or more than 4.00 eV.

The foregoing description of the exemplary embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.

### Brief Description of the Reference Symbols

100: image forming apparatus
1Y, 1M, 1C, 1K: image forming unit
10: primary transfer unit
11: photoreceptor
12: charger
13: laser exposure device
14: developer
15: intermediate transfer belt
16: primary transfer roll
17: photoreceptor cleaner
20: secondary transfer unit
22: secondary transfer roll
25: back roll
26: power supply roll
31: drive roll
32: support roll
33: tension applying roll
34: cleaning back roll
35: intermediate transfer belt cleaner
40: control unit
42: reference sensor
43: image density sensor
50: paper storage portion
51: paper feeding roll
52: transport roll
53: transport guide
55: transport belt
56: fixing inlet guide
60: fixing device
62: heating roll
63: pressurizing roll
66: heating source

## Claims

1. A siloxane compound film comprising:
a siloxane compound including Si, O, C, and H as constituent elements,
wherein the siloxane compound film has a peak in a range of 100 eV or more and 103 eV or less in a spectrum measured by X-ray photoelectron spectroscopy (XPS), and
a half-value width of the peak is 1.80 eV or more and 4.00 eV or less.

2. The siloxane compound film according to claim 1,
wherein the siloxane compound film has an Si-O bond and an Si-R bond (R represents a group including at least one of an alkyl group or a phenyl group).

3. The siloxane compound film according to claim 2,
wherein R represents a group including an alkyl group.

4. The siloxane compound film according to any one of claims 1 to 3,
wherein the half-value width of the peak is 2.00 eV or more and 3.00 eV or less.

5. The siloxane compound film according to any one of claims 1 to 4,
wherein an atomic weight ratio (C/Si) of C to Si is 0.30 or more.

6. A member comprising:
a base material; and
a surface layer that is provided on the base material and is constituted of the siloxane compound film according to any one of claims 1 to 5.

7. The member according to claim 6,
wherein the base material is a metal base material.

8. A fixing device comprising:
a first rotating body; and
a second rotating body disposed in contact with an outer surface of the first rotating body,
wherein at least one of the first rotating body or the second rotating body is constituted of the member according to claim 6 or 7.

9. An image forming apparatus comprising:
an image holder;
a charging device that charges a surface of the image holder;
an electrostatic latent image forming device that forms an electrostatic latent image on the charged surface of the image holder;
a developing device that accommodates a developer containing a toner and develops the electrostatic latent image formed on the surface of the image holder with the developer to form a toner image;
a transfer device that transfers the toner image onto a surface of a recording medium; and
the fixing device according to claim 8, that fixes the toner image on the surface of the recording medium.

10. A method of manufacturing the siloxane compound film according to any one of claims 1 to 5, the method comprising:
forming the siloxane compound film by plasma enhanced chemical vapor deposition (plasma CVD) using a raw material siloxane compound as a raw material.
